# EUROPÄISCHE PATENTSCHRIFT

(11) **EP 3 186 841 B1**
(45) Veröffentlichungstag und Bekanntmachung des Hinweises auf die Patenterteilung: **25.07.2018**
(21) Anmeldenummer: 15753358.9
(22) Anmeldetag: 19.08.2015
(51) Int. Cl.: H01L 35/32

(54) **THERMOELEKTRISCHES MODUL**
THERMOELECTRIC MODULE
MODULE THERMOÉLECTRIQUE

(30) Priorität: 26.08.2014 DE 102014216974
(43) Veröffentlichungstag der Anmeldung: 05.07.2017
(73) Patentinhaber: Mahle International GmbH, 70376 Stuttgart (DE)
(72) Erfinder: HIMMER, Thomas, 73326 Reichenbach (DE); LÄMMLE, Christopher, 70439 Stuttgart (DE)
(74) Vertreter: BRP Renaud & Partner mbB Rechtsanwälte Patentanwälte Steuerberater
(86) Internationale Anmeldenummer: PCT/EP2015/069014
(87) Internationale Veröffentlichungsnummer: WO 2016/030242

(56) Entgegenhaltungen:
- EP-A2- 1 615 274
- DE-A1-102007 050 860
- DE-A1-102011 005 246
- JP-A- H11 190 782
- US-A- 5 841 064
- US-A1- 2007 028 955
- US-A1- 2013 098 418

## Beschreibung

Die vorliegende Erfindung betrifft ein thermoelektrisches Modul mit den Merkmalen des Oberbegriffs des Anspruchs 1.

Aus der DE 15 39 322 A1 ist ein thermoelektrisches Modul bekannt, das mehrere thermoelektrische Elemente in Form von positiv und negativ dotierten Halbleitermaterialien aufweist, die über mehrere Leiterbrücken elektrisch verschaltet sind. Das thermoelektrische Modul weist an seiner Kaltseite eine Kaltseitenwand auf, die mit mehreren kaltseitigen Leiterbrücken wärmeleitend, elektrisch isoliert und fest verbunden ist. Analog dazu weist das thermoelektrische Modul an seiner Warmseite eine Warmseitenwand auf, die mit mehreren warmseitigen Leiterbrücken wärmeleitend, elektrisch isoliert und fest verbunden ist. Die thermoelektrischen Elemente sind dabei zwischen Kaltseitenwand und Warmseitenwand angeordnet, so dass sie sich zwischen den kaltseitigen und warmseitigen Leiterbrücken erstrecken. Beim bekannten thermoelektrischen Modul sind die Kaltseitenwand und die Warmseitenwand jeweils durch einen Aluminiumblock gebildet, die sich durch eine gute Wärmeleitfähigkeit auszeichnen und ohne gegenseitigen Kontakt angeordnet sind.

Aus der DE 601 33 795 T2 ist ein Verfahren zum Herstellen einer elektrisch leitenden Schicht auf einer dielektrischen Oberfläche bekannt. Hierzu wird ein Substrat mit einer Lösung behandelt, die Bismut-Ionen enthält. Anschließend wird das Substrat mit einer Sulfidlösung behandelt. Schließlich wird ein Metallplattieren des Substrats durchgeführt.

Zur verbesserten Handhabung derartiger thermoelektrischer Module kann ein metallisches Modulgehäuse vorgesehen sein, das einen Modulinnenraum umschließt, in dem die thermoelektrischen Elemente sowie die Leiterbrücken angeordnet sind. Das Modulgehäuse weist dann die Kaltseitenwand und die Warmseitenwand auf. Das Modulgehäuse lässt sich hermetisch dicht verschließen, was die Handhabung, die Montage und den Einsatz der thermoelektrischen Module erheblich vereinfacht.

Je nach Anwendungsfall können die thermoelektrischen Module einer Vielzahl von Temperaturwechseln ausgesetzt sein, die zu entsprechenden thermisch bedingten Dehnungseffekten führen. Bei der Verwendung von gekapselten thermoelektrischen Modulen, die ein dicht verschlossenes Modulgehäuse besitzen, können die thermischen Wechselbelastungen die Festigkeit bzw. die Dichtigkeit des Modulgehäuses beeinträchtigen.

Ein gattungsgemäßes thermoelektrisches Modul ist aus der US 2013/0098418 A1 bekannt und unterscheidet sich von den vorstehend genannten Modulen insbesondere dadurch, dass die Kaltseitenwand und die Warmseitenwand aus verschiedenen Metallwerkstoffen bestehen, die sich durch unterschiedliche Wärmeausdehnungskoeffizienten voneinander unterscheiden. Weitere Module dieser oder ähnlicher Art sind aus der US 2007/028955 A1 und aus der DE 10 2007 050860 A1 bekannt.

Die vorliegende Erfindung beschäftigt sich mit dem Problem, für ein thermoelektrisches Modul, das ein Modulgehäuse aufweist, eine verbesserte Ausführungsform anzugeben, die sich insbesondere durch eine erhöhte Standzeit auszeichnet.

Dieses Problem wird erfindungsgemäß durch den Gegenstand des unabhängigen Anspruchs gelöst. Vorteilhafte Ausführungsformen sind Gegenstand der abhängigen Ansprüche.

Die Erfindung beruht auf dem allgemeinen Gedanken, die Kaltseitenwand und die Warmseitenwand des Modulgehäuses aus unterschiedlichen Metallwerkstoffen herzustellen, die sich vorzugsweise durch unterschiedliche Wärmeausdehnungskoeffizienten voneinander unterscheiden. Die Erfindung beruht hierbei auf der Überlegung, dass die unterschiedlichen thermischen Belastungen an der Kaltseite und an der Warmseite hinsichtlich der auftretenden Temperaturdifferenzen unterschiedlich stark ausfallen. Durch die Verwendung unterschiedlicher Metallwerkstoffe mit unterschiedlichen Wärmedehnungskoeffizienten lassen sich die thermischen Dehnungseffekte an derjenigen Seite, an der die Temperaturdifferenzen größer sind, reduzieren, während sie an derjenigen Seite, an der die auftretenden Temperaturdifferenzen geringer sind, im Vergleich dazu größer ausfallen. In Kombination können dadurch die absoluten thermischen Dehnungseffekte der beiden Wände gewissermaßen synchronisiert werden, wodurch eine Differenz der Dehnungseffekte zwischen den beiden Wänden reduziert werden kann. In gleichem Maße lassen sich dann auch thermisch bedingte Spannungen zwischen der Warmseitenwand und der Kaltseitenwand reduzieren, was die Langlebigkeit des Modulgehäuses und somit des thermoelektrischen Moduls verbessert.

Erfindungsgemäß ist die Kaltseitenwand aus einem ersten Metallwerkstoff gebildet, der einen ersten Wärmeausdehnungskoeffizienten aufweist, während die Warmseitenwand aus einem zweiten Metallwerkstoff gebildet ist, der einen zweiten Wärmeausdehnungskoeffizienten aufweist, der kleiner ist als der erste Wärmeausdehnungskoeffizient. Diese Bauweise hat sich für Anwendungsfälle als vorteilhaft herausgestellt, bei denen die maximalen Temperaturdifferenzen an der Warmseite größer ausfallen als an der Kaltseite. Denkbar sind beispielsweise Fahrzeuganwendungen derartiger thermoelektrischer Module, bei denen die Warmseite mit einem Abgasstrang einer Brennkraftmaschine des Fahrzeugs wärmeübertragend gekoppelt ist, während die Kaltseite mit einem Kühlkreis des Fahrzeugs wärmeübertragend gekoppelt ist. Die Abgastemperaturen schwanken dabei in einem deutlich größeren Bereich als die Kühlmitteltemperaturen.

Gemäß einer vorteilhaften Weiterbildung kann der erste Wärmeausdehnungskoeffizient mindestens 25%, vorzugsweise mindestens 50%, insbesondere mindestens 100%, größer sein als der zweite Wärmeausdehnungskoeffizient. Hierdurch lassen sich die thermischen Spannungen aufgrund thermischer Wechselbelastungen zwischen der Warmseitenwand und der Kaltseitenwand signifikant reduzieren.

Gemäß einer anderen Weiterbildung kann der erste Metallwerkstoff ein Aluminiumwerkstoff sein. Als Aluminiumwerkstoff kommt sowohl Aluminiummetall als auch eine Aluminiumlegierung in Betracht. Zusätzlich oder alternativ kann der zweite Metallwerkstoff ein Titanwerkstoff sein. Als Titanwerkstoff kommt sowohl Titanmetall als auch eine Titanlegierung in Betracht. Der Wärmeausdehnungskoeffizient von Aluminium ist deutlich größer als der Wärmeausdehnungskoeffizient von Titan. Ferner ist der Wärmeausdehnungskoeffizient von Aluminium größer als derjenige von Eisen, während der Wärmeausdehnungskoeffizient von Titan kleiner ist als derjenige von Eisen. Somit ergeben sich für das Modulgehäuse zunächst folgende Kombinationsmöglichkeiten. Gemäß einer ersten Möglichkeit besteht die Kaltseitenwand aus einem Aluminiumwerkstoff während die Warmseitenwand aus einem Titanwerkstoff besteht. Gemäß einer zweiten Möglichkeit besteht die Kaltseitenwand wieder aus einem Aluminiumwerkstoff, während nun die Warmseitenwand aus einem Eisenwerkstoff besteht. Gemäß einer dritten Möglichkeit besteht nun die Kaltseitenwand aus einem Eisenwerkstoff, während die Warmseitenwand aus einem Titanwerkstoff besteht. Als Eisenwerkstoffe kommen vor allem Stahlwerkstoffe, insbesondere Edelstahlwerkstoffe, in Betracht.

Ferner können als Eisenwerkstoff einerseits austenitische Eisenwerkstoffe und andererseits ferritische Eisenwerkstoffe in Betracht kommen, die jeweils wieder als Stahl oder Edelstahl ausgestaltet sein können. Ein ferritischer Eisenwerkstoff, der im Folgenden auch als Ferrit bezeichnet werden kann, besitzt einen deutlich niedrigeren Wärmeausdehnungskoeffizienten als ein austenitischer Eisenwerkstoff, der auch als Austenit bezeichnet werden kann. Somit kann gemäß einer vorteilhaften Ausführungsform die Kaltseitenwand zweckmäßig durch einen Austenit gebildet sein, während es für die Warmseitenwand vorteilhaft sein kann, diese aus einem Ferrit herzustellen. Somit lassen sich die vorstehend genannten drei Möglichkeiten optimieren.

Alternativ ist jedoch auch eine Ausführungsform denkbar, bei der beide Seitenwände jeweils aus einem Eisenwerkstoff hergestellt sind, wobei dann der erste Metallwerkstoff für die Kaltseite ein Austenit ist, während der zweite Metallwerkstoff für die Warmseite dann ein Ferrit ist.

Bei einer Ausführungsform, bei welcher der erste Metallwerkstoff ein Aluminiumwerkstoff ist, kann die Kaltseitenwand eine elektrisch isolierende Eloxalschicht aufweisen, welche im Wesentlichen aus Aluminiumoxid bestehen kann. Für den Fall, dass der zweite Metallwerkstoff ein Titanwerkstoff ist, kann die Warmseitenwand eine elektrisch isolierende Eloxalschicht aufweisen, welche im Wesentlichen aus Titanoxid bestehen kann und auch als Hard-Coat bezeichnet wird. Mit Hilfe einer derartigen Eloxalschicht lässt sich besonders einfach eine effiziente elektrische Isolation zwischen der jeweiligen Seitenwand und den Leiterbrücken realisieren, die sich außerdem durch einen relativ geringen thermischen Widerstand auszeichnet.

Erfindungsgemäß ist zumindest einer der Metallwerkstoffe ein Eisenwerkstoff, wobei dann beim ersten Metallwerkstoff die Kaltseitenwand bzw. beim zweiten Metallwerkstoff die Warmseitenwand eine elektrisch isolierende glaskeramische Sol-Gel-Beschichtung oder eine Silizium(di)oxid- oder Polysilazen-Beschichtung aufweist. Eine derartige Beschichtung lässt sich besonders einfach auf die jeweilige Seitenwand aus einem Eisenwerkstoff aufbringen und zeichnet sich einerseits durch eine effiziente elektrische Isolation und andererseits durch einen geringen thermischen Widerstand, also durch eine relativ gute Wärmeleitfähigkeit aus.

Gemäß einer Weiterbildung können die Leiterbrücken auf die jeweilige Eloxalschicht oder auf die jeweilige Sol-Gel-Beschichtung thermisch aufgespritzt sein. Das Aufspritzen der Leiterbrücken lässt sich besonders einfach im Rahmen einer Großserienfertigung realisieren, ohne dass es dabei zu einer Beschädigung der jeweiligen Eloxalschicht bzw. der Sol-Gel-Beschichtung kommt.

Gemäß einer Weiterbildung können die Leiterbrücken mehrlagig aufgespritzt sein und dementsprechend eine auf die jeweilige Eloxalschicht oder auf die jeweilige Sol-Gel-Beschichtung aufgespritzte erste Lage aus einem Aluminiumwerkstoff oder aus einem Titanwerkstoff oder aus einem Eisenwerkstoff und eine auf die erste Lage aufgespritzte zweite Lage aus einem Kupferwerkstoff oder aus einem Nickelwerkstoff aufweisen. Durch die Zweilagigkeit der aufgespritzten Leiterbrücken kann die Dauerhaltbarkeit der Verbindung zwischen den Leiterbrücken und der jeweiligen Seitenwand bzw. der jeweiligen Eloxalbeschichtung oder Sol-Gel-Beschichtung erheblich verbessert werden. Durch entsprechende Auswahl des Werkstoffs für die erste Lage, lässt sich der Wärmeausdehnungskoeffizient der ersten Lage gleich oder annähernd gleich groß wählen wie derjenige der zugehörigen Seitenwand. Die Auswahl des Metallwerkstoffs für die zweite Lage, die auf die erste Lage aufgespritzt wird, erfolgt so, dass die Anbindung der Leiterbrücken an die thermoelektrischen Elemente vereinfacht ist. Üblicherweise werden die thermoelektrischen Elemente mit den Leiterbrücken verlötet. Eine zuverlässige Lötverbindung lässt sich beispielsweise dann erreichen, wenn die zweite Lage aus einem Kupferwerkstoff oder Nickelwerkstoff besteht. Zusätzlich ist es noch denkbar, auf die zweite, aus einem Kupferwerkstoff bestehende Lage eine dritte, aus einem Nickelwerkstoff bestehende Lage aufzubringen, um eine Diffusionsbarriere zu schaffen.

Bei einer anderen Ausführungsform kann vorgesehen sein, dass die Leiterbrücken als separate Bauteile ausgestaltet sind und auf die jeweilige Eloxalschicht oder auf die jeweilige Sol-Gel-Beschichtung aufgeklebt sind. Auch eine derartige Ausführungsform lässt sich vergleichsweise preiswert realisieren.

Bei einer anderen Ausführungsform kann vorgesehen sein, dass auf die jeweilige Eloxalschicht oder auf die jeweilige Sol-Gel-Beschichtung zumindest im Bereich der jeweiligen Leiterbrücken eine Metallschicht aufgebracht ist. Die jeweilige Leiterbrücke kann dann auf diese Metallschicht aufgalvanisiert sein oder als separates Bauteil ausgestaltet und auf die jeweilige Metallschicht aufgelötet sein. Auch diese Bauform zeichnet sich durch eine zuverlässige Fixierung der Leiterbrücken an der jeweiligen Seitenwand sowie durch eine vereinfachte Anbindung der Leiterbrücken an die thermoelektrischen Elemente aus.

Gemäß einer Weiterbildung kann die jeweilige Metallschicht zumindest im Bereich der Leiterbrücken auf die Eloxalschicht oder auf die Sol-Gel-Beschichtung aufgalvanisiert sein oder aufgedruckt und eingebrannt sein oder mittels eines CVD-Verfahrens oder mittels eines PVD-Verfahrens aufgebracht sein. CVD steht dabei für Chemical Vapor Deposition und beschreibt eine chemische Gasphasenabscheidung. PVD steht für Physical Vapor Deposition und beschreibt eine physikalische Gasphasenabscheidung. Beim PVD-Verfahren befindet sich das Rohmaterial, das abgeschieden werden soll, in einem festen Stadium, während es sich beim CVD-Verfahren in einem gasförmigen Zustand befindet.

Alternativ können die Leiterbrücken auf die jeweilige Eloxalschicht bzw. auf die jeweilige Sol-Gel-Beschichtung aufgedruckt und eingebrannt werden, was sich im Rahmen einer Serienfertigung preiswert realisieren lässt.

Entsprechend einer anderen vorteilhaften Ausführungsform kann die Kaltseitenwand entlang eines den Gehäuseinnenraum zwischen Kaltseite und Warmseite in einer Umlaufrichtung einfassenden Rands direkt mit der Warmseitenwand verlötet sein. Im Extremfall weist das Modulgehäuse dann nur die Warmseitenwand und die Kaltseitenwand auf, die miteinander verlötet sind und das Modulgehäuse bilden.

Alternativ kann vorgesehen sein, dass zwischen der Kaltseitenwand und der Warmseitenwand im Bereich eines den Gehäuseinnenraum zwischen Kaltseite und Warmseite in einer Umlaufrichtung einfassenden Rands ein separater Verbindungsrahmen vorgesehen ist, der mit der Kaltseitenwand und mit der Warmseitenwand verlötet ist. Bei dieser Ausführungsform besteht das Modulgehäuse somit aus drei Bestandteilen, nämlich aus der Kaltseitenwand, der Warmseitenwand und dem Verbindungsrahmen. Bei dieser Ausführungsform lassen sich die Seitenwände hinsichtlich ihrer Geometrie besonders einfach und somit preiswert realisieren.

Bei einer anderen Ausführungsform kann die Kaltseitenwand einen Kaltseitenrahmen aufweisen, der entlang eines den Gehäuseinnenraum zwischen der Kaltseite und der Warmseite in einer Umlaufrichtung einfassenden Rands des Modulgehäuses geschlossen umläuft und an der Kaltseitenwand angebracht ist. Analog dazu kann die Warmseitenwand einen Warmseitenrahmen aufweisen, der entlang des Rands geschlossen umläuft und an der Warmseitenwand angebracht ist. Der Kaltseitenrahmen kann nun mit dem Warmseitenrahmen verlötet sein, um das Modulgehäuse dicht zu verschließen. Auch bei dieser Ausführungsform können die Seitenwände einen vergleichsweise einfachen Aufbau besitzen, wodurch sie preiswert herstellbar sind. Mit Hilfe des jeweiligen Seitenrahmens lassen sich beim Herstellen der thermoelektrischen Module die Leiterbrücken und die thermoelektrischen Elemente einfacher positionieren.

Bei einer vorteilhaften Weiterbildung kann der Kaltseitenrahmen wie die jeweiligen kaltseitigen Leiterbrücken an der Kaltseitenwand angebracht sein. Entsprechendes gilt dann zweckmäßig auch für den Warmseitenrahmen, der demnach wie die jeweiligen warmseitigen Leiterbrücken an der Warmseitenwand angebracht sein kann. Zur Anbringung des jeweiligen Seitenrahmens an der jeweiligen Seitenwand kann somit auf die vorstehend erläuterten Varianten zur Anbringung der Leiterbrücken an den Seitenwänden verwiesen werden, wie z.B. Ankleben, Aufgalvanisieren, Aufdrucken, Aufspritzen.

Weitere wichtige Merkmale und Vorteile der Erfindung ergeben sich aus den Unteransprüchen, aus den Zeichnungen und aus der zugehörigen Figurenbeschreibung anhand der Zeichnungen.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Bevorzugte Ausführungsbeispiele der Erfindung sind in den Zeichnungen dargestellt und werden in der nachfolgenden Beschreibung näher erläutert, wobei sich gleiche Bezugszeichen auf gleiche oder ähnliche oder funktional gleiche Komponenten beziehen.

Es zeigen, jeweils schematisch
- Fig. 1: einen stark vereinfachten Querschnitt eines thermoelektrischen Moduls,
- Fig. 2 bis 7: jeweils einen Querschnitt einer Kaltseitenwand des thermoelektrischen Moduls bei verschiedenen Ausführungsformen,
- Fig. 8 bis 13: jeweils einen Querschnitt einer Warmseitenwand des thermoelektrischen Moduls bei verschiedenen Ausführungsformen,
- Fig. 14 und15: jeweils eine isometrische Ansicht auf eine Seitenwand des thermoelektrischen Moduls bei verschiedenen Ausführungsformen,
- Fig. 16 bis18: jeweils einen Querschnitt des thermoelektrischen Moduls in einem Randbereich eines Modulgehäuses bei verschiedenen Ausführungsformen.

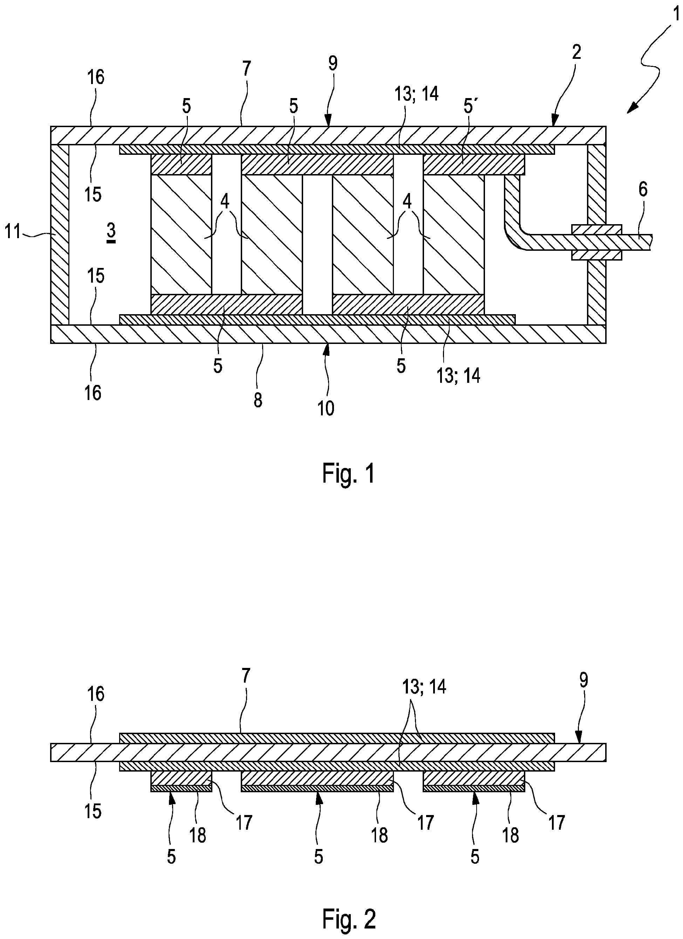

Entsprechend Fig. 1 umfasst ein thermoelektrisches Modul 1 ein metallisches Modulgehäuse 2, das einen Modulinnenraum 3 umschließt. Im Modulinnenraum 3 sind mehrere thermoelektrische Elemente 4 angeordnet, bei denen es sich um Halbleiterelemente handelt, die in der Regel abwechselnd p-dotiert, also positiv dotiert und n-dotiert, also negativ dotiert sind. Im Modulinnenraum 3 sind ferner mehrere elektrisch leitende Leiterbrücken 5 angeordnet, mit deren Hilfe die thermoelektrischen Elemente 4 elektrisch verschaltet sind. Insbesondere verbinden derartige Leiterbrücken 5 ein p-dotiertes thermoelektrisches Element 4 mit einem dazu benachbarten n-dotierten thermoelektrischen Element 4. Mit Hilfe der Leiterbrücken 5 sind mehrere thermoelektrische Elemente 4 in Reihe geschaltet. Ebenso können mit Hilfe der Leiterbrücken 5 mehrere Reihenschaltungen der thermoelektrischen Elemente 4 parallel geschaltet werden. Außerdem können zwei derartige Leiterbrücken 5 auch zum Anschließen eines elektrischen Kontakts 6 dienen. Eine derartige Anschluss-Leiterbrücke ist in Fig. 1 mit 5' bezeichnet. Jedes thermoelektrische Modul 1 weist zumindest zwei derartige elektrische Kontakte 6 auf, nämlich für einen Minus-Pol-Anschluss und einen Plus-Pol-Anschluss. In Fig. 1 ist nur einer der Kontakte 6 erkennbar.

Die Verschaltung der thermoelektrischen Elemente 4 mit Hilfe der Leiterbrücken 5 erfolgt in üblicher Weise derart, dass an den elektrischen Kontakten 6 des Moduls 1 eine elektrische Spannung entsteht, wenn zwischen einer Kaltseite 7 des Moduls 1 und einer Warmseite 8 des Moduls 1 eine Temperaturdifferenz auftritt. Somit nutzen thermoelektrische Module 1 den sogenannten Seebeck-Effekt, der einer Inversion des Peltier-Effekts entspricht.

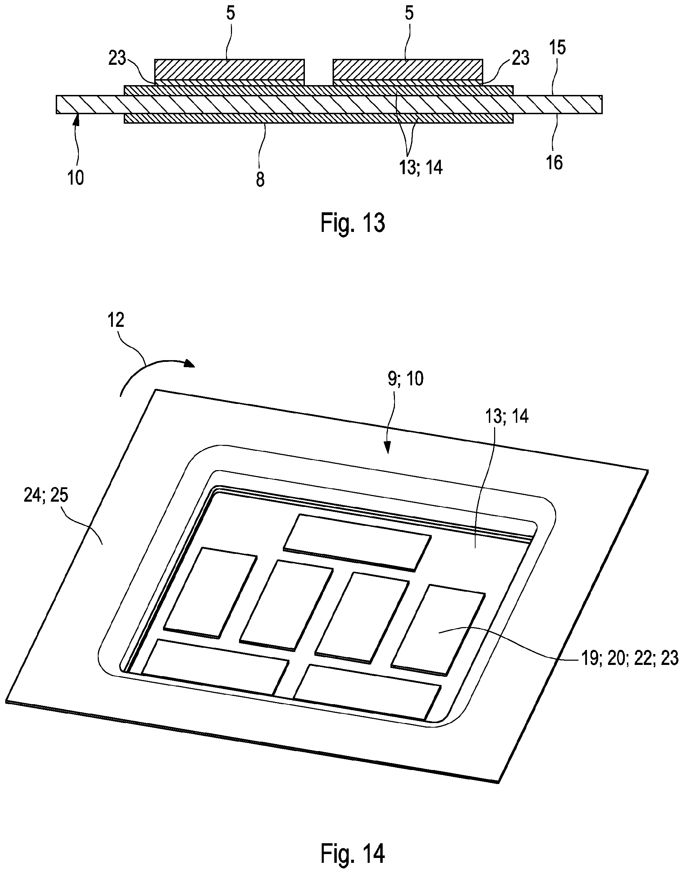

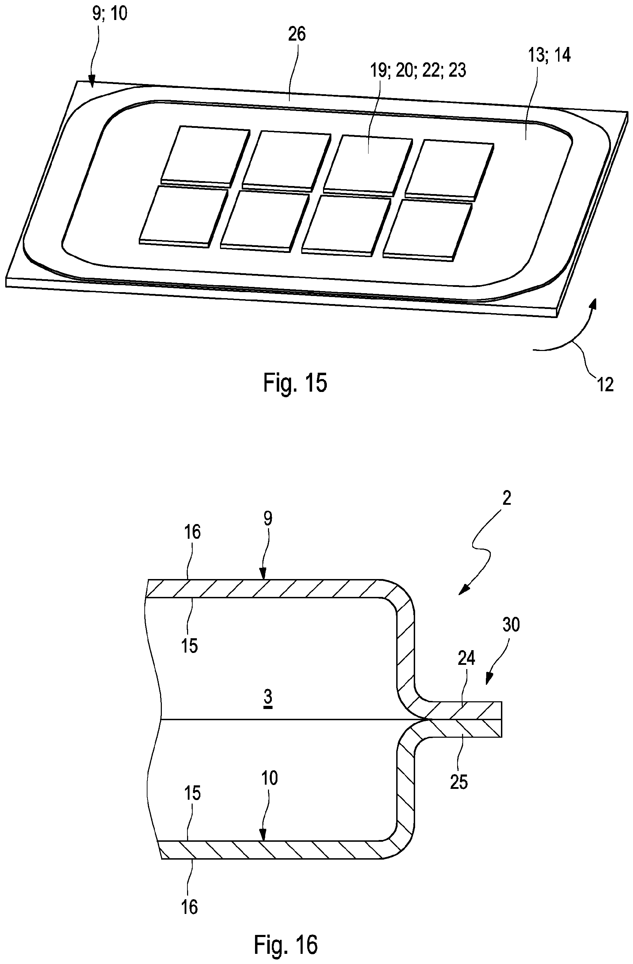

Das Modulgehäuse 2 weist an seiner Kaltseite 7 eine Kaltseitenwand 9 auf, die mit mehreren kaltseitigen Leiterbrücken 5 wärmeleitend, elektrisch isoliert und fest verbunden ist. An der gegenüberliegenden Warmseite 8 weist das Modulgehäuse 2 eine Warmseitenwand 10 auf, die mit mehreren warmseitigen Leiterbrücken 5 wärmeleitend, elektrisch isoliert und fest verbunden ist. Die thermoelektrischen Elemente 4 erstrecken sich geometrisch zwischen den kaltseitigen und warmseitigen Leiterbrücken 5. Im Beispiel der Fig. 1 ist zwischen der Kaltseitenwand 9 und der Warmseitenwand 10 außerdem ein Verbindungsrahmen 11 vorgesehen, der den Gehäuseinnenraum 3 zwischen der Kaltseite 7 und der Warmseite 8 in einer in den Figuren 14 und 15 durch einen Doppelpfeil angedeuteten Umlaufrichtung 12 einfassenden Randbereichs erstreckt. Der Verbindungsrahmen 11 ist im Beispiel der Fig. 1 bezüglich der Kaltseitenwand 9 und bezüglich der Warmseitenwand 10 als separates Bauteil ausgestaltet und mit beiden Seitenwänden 9, 10 auf geeignete Weise fest verbunden, insbesondere damit verlötet.

Beim hier vorgestellten Modul 1 ist die Kaltseitenwand 9 aus einem ersten Metallwerkstoff hergestellt, der einen ersten Wärmeausdehnungskoeffizienten aufweist. Die Warmseitenwand 10 ist dagegen aus einem vom ersten Metallwerkstoff verschiedenen zweiten Metallwerkstoff gebildet, der einen zweiten Wärmeausdehnungskoeffizienten aufweist, der sich vom ersten Wärmeausdehnungskoeffizienten unterscheidet. Demnach ist der erste Wärmeausdehnungskoeffizient entweder größer oder kleiner als der zweite Wärmeausdehnungskoeffizient. Bevorzugt ist eine Ausführungsform, bei welcher der erste Wärmeausdehnungskoeffizient größer ist als der zweite Wärmeausdehnungskoeffizient. Der größere erste Wärmeausdehnungskoeffizient ist somit der Kaltseitenwand 9 zugeordnet, während der kleinere zweite Wärmeausdehnungskoeffizient der Warmseitenwand 10 zugeordnet ist. Beispielsweise ist der erste Wärmeausdehnungskoeffizient mindestens 25% größer als der zweite Wärmeausdehnungskoeffizient. Bevorzugt ist der erste Wärmeausdehnungskoeffizient mindestens 50% größer als der zweite Wärmeausdehnungskoeffizient. Besonders vorteilhaft ist eine Ausführungsform, bei welcher der erste Wärmeausdehnungskoeffizient mindestens doppelt so groß ist wie der zweite Wärmeausdehnungskoeffizient.

Der erste Metallwerkstoff, aus dem die Kaltseitenwand 9 hergestellt ist, ist bevorzugt ein Aluminiumwerkstoff, während der zweite Metallwerkstoff, aus dem die Warmseitenwand 10 besteht, bevorzugt ein Titanwerkstoff ist. Somit werden im Modulgehäuse 2 bevorzugt eine Kaltseitenwand 9 aus Aluminium mit einer Warmseitenwand 10 aus Titan kombiniert. Bei einer anderen vorteilhaften Ausführungsform werden im Modulgehäuse 2 eine Kaltseitenwand 9 aus einem austenitischen Eisenwerkstoff mit einer Warmseitenwand 10 aus einem ferritischen Eisenwerkstoff miteinander kombiniert. Bei der Aluminium-Titan-Kombination ist der erste Wärmeausdehnungskoeffizient mehr als doppelt so groß als der zweite Wärmeausdehnungskoeffizient. Bei der Austenit-Ferrit-Kombination ist der erste Wärmeausdehnungskoeffizient etwa 50% größer als der zweite Wärmeausdehnungskoeffizient.

Es ist klar, dass auch andere Materialkombinationen innerhalb des Modulgehäuses 2 vorstellbar sind, solange eine hinreichende Differenz zwischen den Wärmeausdehnungskoeffizienten der beiden Seitenwände 9, 10 vorliegt. Beispielsweise lässt sich eine Kaltseitenwand 9 aus Aluminium mit einer Warmseitenwand 10 aus Eisen kombinieren. Ebenso lässt sich eine Kaltseitenwand 9 aus Eisen mit einer Warmseitenwand 10 aus Titan kombinieren.

Wie sich Fig. 1 entnehmen lässt, sind die beiden Seitenwände 9, 10 des Modulgehäuses 2 jeweils zumindest an einer dem Modulinnenraum 3 zugewandten Seite mit einer Beschichtung 13 oder 14 versehen, die zwischen der jeweiligen Seitenwand 9, 10 und den zugehörigen Leiterbrücken 5 angeordnet ist. Die Beschichtung 13 oder 14 ist so gestaltet, dass sie einerseits eine elektrische Isolation bewirkt und andererseits eine relativ gute Wärmeleitung zwischen der jeweiligen Seitenwand 9, 10 und den jeweils zugeordneten Leiterbrücken 5 gewährleistet

Sofern für die Kaltseitenwand 9 als Metallwerkstoff ein Aluminiumwerkstoff verwendet wird, handelt es sich bei der Beschichtung bevorzugt um eine Eloxalschicht 13. Ist die Kaltseitenwand 9 dagegen aus einem Eisenwerkstoff, insbesondere aus einem Austenit, hergestellt, handelt es sich bei der Beschichtung bevorzugt um eine Sol-Gel-Beschichtung 14. Ist die Warmseitenwand 10 aus einem Titanwerkstoff hergestellt, wird wieder eine Eloxalschicht 13 bevorzugt. Ist dagegen die Warmseitenwand 10 aus einem Eisenwerkstoff, bevorzugt aus einem Ferrit, hergestellt, wird wieder eine Sol-Gel-Beschichtung 14 bevorzugt. Die nachfolgende Beschreibung spezieller Ausführungsformen anhand der Figuren 2 bis 13 legt dabei diese bevorzugten Ausführungsformen zugrunde, so dass immer dann, wenn die Kaltseitenwand 9 aus einem Aluminiumwerkstoff hergestellt ist, eine Eloxalschicht 13 vorliegt. Ist die Kaltseitenwand 9 dagegen aus einem Eisenwerkstoff hergestellt, liegt eine Sol-Gel-Beschichtung 14 vor. Entsprechendes gilt dann auch für die Warmseitenwand 10. Ist die Warmseitenwand 10 aus einem Titanwerkstoff hergestellt, liegt eine Eloxalschicht 13 vor. Ist die Warmseitenwand 10 dagegen aus einem Eisenwerkstoff hergestellt, liegt eine Sol-Gel-Beschichtung 14 vor.

Zunächst ist den Figuren 2 bis 13 zu entnehmen, dass es zweckmäßig ist, die jeweilige Seitenwand 9, 10 sowohl an ihrer dem Modulinnenraum 3 zugewandten Innenseite 15 als auch an ihrer vom Modulinnenraum 3 abgewandten Außenseite 16 mit einer derartigen Beschichtung 13 oder 14 zu versehen, wodurch die Modulgehäuse 2 insoweit elektrisch isoliert sind, beispielsweise um sie mit metallischen Wärmequellen zu kontaktieren.

Bei der in Fig. 2 gezeigten Ausführungsform sind die Leiterbrücken 5 auf die jeweilige Beschichtung 13 oder 14, also entweder auf die Eloxalschicht 13 oder auf die Sol-Gel-Beschichtung 14 thermisch aufgespritzt. Hierbei kommt ein übliches thermisches Spritzverfahren zur Anwendung, also beispielsweise Kaltgasspritzen oder Plasmaspritzen. Hierzu kann es vorab notwendig sein, die jeweilige Seitenwand 9, 10 auf geeignete Weise vorzubereiten, beispielsweise durch Sandstrahlen und/oder Anwärmen. Zum Anspritzen der kaltseitigen Leiterbrücken 5 wird dabei ein Metallwerkstoff bevorzugt, der einen ähnlichen Wärmeausdehnungskoeffizienten aufweist wie die Kaltseitenwand 9. Ist die Kaltseitenwand 9 beispielsweise aus einem Aluminiumwerkstoff hergestellt, wird auch für die kaltseitigen Leiterbrücken 5 ein Aluminiumwerkstoff verwendet.

Im Beispiel der Fig. 2 sind die Leiterbrücken 5 zweilagig aufgespritzt, wobei eine erste Lage 17 unmittelbar auf die jeweilige Beschichtung 13 oder 14 aufgespritzt ist, während eine zweite Lage 18 anschließend auf die erste Lage 17 aufgespritzt ist. Die erste Lage 17 ist hinsichtlich des Wärmeausdehnungskoeffizienten an die Kaltseitenwand 9 angepasst, während die zweite Lage 18 hinsichtlich einer möglichst einfachen Verbindung mit den thermoelektrischen Elementen 4 ausgewählt ist. Beispielsweise kann die zweite Lage 18 aus einem Kupferwerkstoff oder aus einem Nickelwerkstoff hergestellt sein, was die Reduzierung von Lötverbindungen vereinfacht.

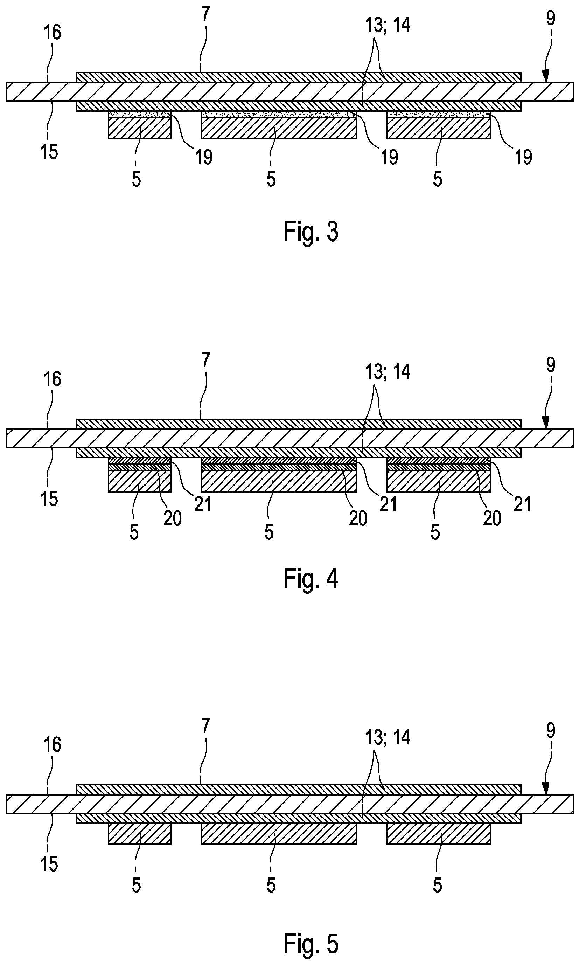

Bei der in Fig. 3 gezeigten Ausführungsform sind die Leiterbrücken 5 in Form von separaten Bauteilen vorgesehen, die auf geeignete Weise auf die jeweilige Beschichtung 13 oder 14 aufgeklebt sind. In Fig. 3 ist eine entsprechende Klebstoffschicht mit 19 bezeichnet.

Bei der in Fig. 4 gezeigten Ausführungsform wird zunächst auf die jeweilige Beschichtung 13 oder 14 zumindest im Bereich der kaltseitigen Leiterbrücken 5 jeweils eine Metallschicht 20 aufgebracht. Diese Metallschicht 20 kann grundsätzlich direkt auf die jeweilige Beschichtung 13 oder 14 aufgebracht werden. In Fig. 4 ist jedoch eine bevorzugte Ausführungsform gezeigt, bei der vorab eine Aktivierungsschicht 21 oder Haftgrundschicht 21 auf die jeweilige Beschichtung 13 oder 14 aufgebracht wird, auf die dann die jeweilige Metallschicht 20 aufgebracht wird. Die Leiterbrücken 5 können dann beispielsweise auf die Metallschicht 20 aufgalvanisiert werden. Ebenso ist es möglich, die Leiterbrücken 5 in Form separater Bauteile auf die Metallschicht 20 aufzulöten.

Die Metallschicht 20 kann ihrerseits auf die jeweilige Beschichtung 13 oder 14 bzw. auf die jeweilige Aktivierungsschicht 21 aufgalvanisiert sein. Ebenso ist es möglich, die Metallschicht 20 auf die Beschichtung 13 oder 14 bzw. auf die Aktivierungsschicht 21 aufzudrucken und einzubrennen. Hierbei kann beispielsweise ein einfaches Siebdruckverfahren zum Einsatz kommen. Alternativ ist es ebenso möglich, die Metallschicht 20 mittels eines CVD-Verfahrens oder mittels eines PVD-Verfahrens auf der Beschichtung 13 oder 14 bzw. auf der jeweiligen Aktivierungsschicht 21 aufzubringen.

Fig. 5 zeigt eine Ausführungsform, bei welcher die Leiterbrücken 5 auf die jeweilige Beschichtung 13 oder 14 unmittelbar aufgedruckt werden. Als druckfähiges, pastöses Leiterbrückenmaterial kommt beispielsweise ein Gemisch aus Metallpartikeln, Glaspartikeln und einem geeigneten Binder zur Anwendung. Nach dem Aufbringen des pastösen Leiterbrückenmaterials, beispielsweise im Siebdruckverfahren, erfolgt ein Einbrennen, bei dem sich die Glaspartikel mit der Eloxalschicht 13 bzw. mit der Sol-Gel-Beschichtung 14 verbinden, während das Bindergemisch verdampft. Zurück bleibt dann eine poröse aber massive metallische Leiterbrückenstruktur, z.B. aus Kupfer bzw. auf einer Kupferbasis, die über die Glasbestandteile fest mit der jeweiligen Beschichtung 13 oder 14 verbunden ist. Gleichzeitig eignet sich diese metallische Leiterbrückenstruktur dann in besonderer Weise zum Herstellen einer Lötverbindung mit den thermoelektrischen Elementen 4.

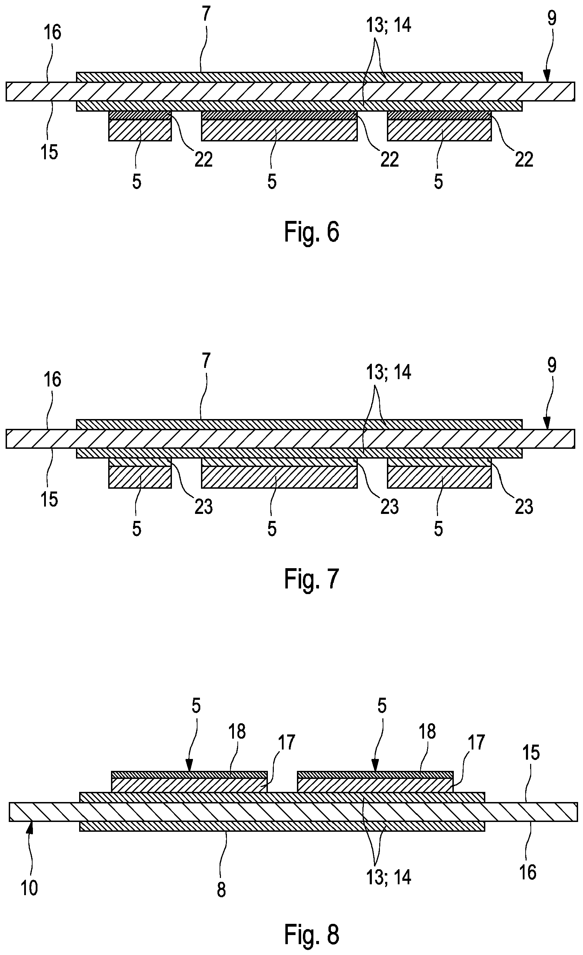

Bei der in Fig. 6 gezeigten Ausführungsform sind die als separate Körper bereitgestellte Leiterbrücken 5 über eine metallische Beschichtungsstruktur 22 oder Metallschicht 22 fest mit der jeweiligen Beschichtung 13 oder 14 verbunden. Diese Beschichtungsstruktur 22 kann in Form eines pastösen Beschichtungsmaterials auf die jeweilige Beschichtung 13, 14 aufgebracht und eingebrannt werden. Beispielsweise besteht dieses pastöse Beschichtungsmaterial aus einem Gemisch von Metallpartikeln, Glaspartikeln und einem Bindergemisch, das druckfähig ist und beispielsweise mittels Siebdruck auf die jeweilige Beschichtung 13, 14 aufgebracht werden kann. Durch das Einbrennen verbinden sich die Glaspartikel der Beschichtungspaste mit der jeweiligen Beschichtung 13 oder 14, während das Bindegemisch verdampft. Übrig bleibt dann die massive metallische Beschichtungsstruktur 22, die beispielsweise als Metallbestandteil Kupfer oder eine Kupferlegierung aufweisen kann.

Schließlich zeigt Fig. 7 eine Ausführungsform, bei welcher ebenfalls eine Metallbeschichtung 23 mittels CVD-Verfahren oder mittels PVD-Verfahren unmittelbar auf die jeweilige Beschichtung 13 oder 14 aufgebracht wird. Auf diese Metallschicht 23 können dann die als separate Bauteile ausgestalteten Leiterbrücken 5 aufgebracht werden, beispielsweise mittels eines Lötverfahrens. Alternativ lassen sich die Leiterbrücken 5 auf diese Metallschicht 23 auch aufgalvanisieren.

Während die Figuren 2 bis 7 Varianten für die Ausgestaltung der Kaltseitenwand 9 bzw. Varianten zur Herstellung der Kaltseitenwand 9 vorstellen, zeigen die Figuren 8 bis 13 dazu analoge Ausgestaltungen der Warmseitenwand 10 bzw. dazu analoge Verfahren zum Herstellen der Warmseitenwand 10.

So zeigt Fig. 8 analog zu Fig. 2 eine Ausführungsform, bei der die warmseitigen Leiterbrücken 5 auf die jeweilige Beschichtung 13 oder 14 thermisch aufgespritzt sind. Gezeigt ist wieder eine zweilagige Ausgestaltung der Leiterbrücken 5. Die erste Lage 17 kann grundsätzlich aus einem Aluminiumwerkstoff hergestellt sein, bevorzugt handelt es sich jedoch um einen Werkstoff, der einen ähnlichen Wärmeausdehnungskoeffizienten aufweist wie die Warmseitenwand 10. Denkbar ist demnach beispielsweise die Verwendung eines Titanwerkstoffs oder eines ferritischen Eisenwerkstoffs für die erste Lage 17 der warmseitigen Leiterbrücken 5. die zweite Lage 18 ist auf die erste Lage 17 aufgespritzt und zeichnet sich durch eine günstige Verbindbarkeit mit den thermoelektrischen Elementen 4 aus. Beispielsweise ist die zweite Lage 18 aus einem Metallwerkstoff auf Kupferbasis oder Nickelbasis hergestellt, so dass sie sich leicht mit den thermoelektrischen Elementen 4 verlöten lässt.

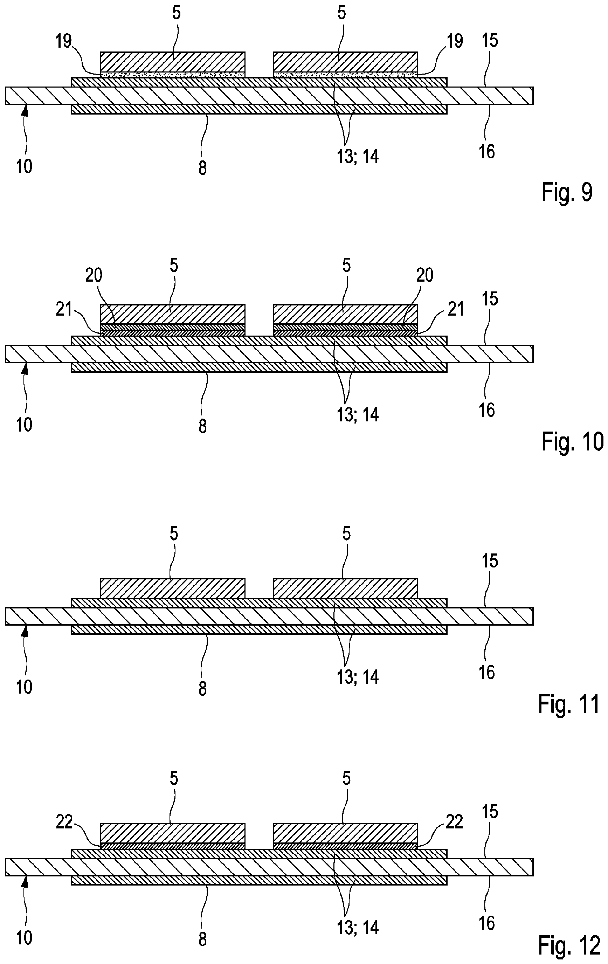

Gemäß Fig. 9, die analog zur Variante der Fig. 3 gestaltet ist, können die warmseitigen Leiterbrücken 5 in Form separater Körper auf die jeweilige Beschichtung 13 oder 14 der Warmseitenwand 10 aufgeklebt sein. Eine entsprechende Klebstoffschicht ist in Fig. 9 ebenfalls mit 19 bezeichnet.

Fig. 10 zeigt eine Ausgestaltung analog zu Fig. 4, bei welcher eine Metallschicht 20 aufgebracht wird. Diese kann entweder direkt auf die jeweilige Beschichtung 13 oder 14 aufgebracht werden. Bevorzugt ist jedoch eine Ausführungsform, bei der zunächst eine Grundierungsschicht oder Aktivierungsschicht 21 unmittelbar auf die jeweilige Beschichtung 13 oder 14 aufgebracht wird, während die vorgenannte Metallschicht 20 dann auf diese Aktivierungsschicht 21 aufgebracht wird. Auch hier kann die Aktivierungsschicht 21 beispielsweise aus Palladium gebildet sein, wobei eine Bekeimung in Säure mit ionogener Metallisierung und vorgelagerten Beiz- und Aktivierungsschritten zur Anwendung kommen können. Anschließend kann ein Ätzschritt erforderlich sein, um überschüssiges Beschichtungsmaterial zu entfernen. Die warmseitigen Leiterbrücken 5 lassen sich dann beispielsweise in Form separater Körper auf die Metallschicht 20 auflöten. Beispielsweise kann hierbei ein zinnhaltiger Lot zum Einsatz kommen.

Fig. 11 zeigt analog zu Fig. 5 eine Variante, bei welcher die warmseitigen Leiterbrücken 5 in Form einer pastösen Masse auf die jeweilige Beschichtung 13 oder 14 aufgebracht und eingebrannt werden. Auch hier kann ein pastöses Leiterbrückenmaterial zur Anwendung kommen, das gedruckt werden kann, beispielsweise mittels Siebdrucktechnik. Diese Leiterbrückenpaste kann ein Gemisch aus Metallpartikel, Glaspartikel und einem Binder bzw. Bindergemisch umfassen. Die Glasbestandteile schaffen die Verbindung zur Beschichtung 13 oder 14, während die Metallpartikel eine gute Verlötbarkeit mit den thermoelektrischen Elementen 4 ermöglichen.

Fig. 12 entspricht im Wesentlichen Fig. 6. Demnach wird hier eine Metallschicht 22 auf die jeweilige Beschichtung 13, 14 der Warmseitenwand 10 aufgedruckt und eingebrannt. Anschließend können die in Form separater Körper bereitgestellten Leiterbrücken 5 galvanisch auf die Metallschicht 22 aufgelötet werden.

Fig. 13 entspricht nun weitgehend Fig. 7 und zeigt demnach eine Ausführungsform, bei welcher eine Metallbeschichtung 23 zumindest im Bereich der warmseitigen Leiterbrücken 5 auf die jeweilige Beschichtung 13 oder 14 der Warmseitenwand 10 mittels eines CVD-Verfahrens oder mittels eines PVD-Verfahrens aufgebracht wird. Anschließend können die Leiterbrücken 5 in Form separater Körper auf die Metallbeschichtung 23 aufgelötet werden. Ebenso ist denkbar, die warmseitigen Leiterbrücken 5 auf die jeweilige Metallschicht 23 aufzubringen. Die Galvanisierung kann dabei mit Strom oder stromlos realisiert werden.

Die Figuren 14 und 15 zeigen jeweils eine der Seitenwände 9, 10, wobei innerhalb des Modulgehäuses 2 zumindest eine der Seitenwände 9, 10 gemäß Fig. 14 oder gemäß Fig. 15 ausgestaltet ist. Zweckmäßig sind Ausführungsformen, bei denen entweder beide Seitenwände 9, 10 gemäß Fig. 14 oder gemäß Fig. 15 ausgestaltet sind.

Gemäß Fig. 14 besitzt die jeweilige Seitenwand 9, 10 einen abgestuften Rand 24 (für die Kaltseitenwand 9) bzw. 25 (für die Warmseitenwand 10). Dieser Rand 24 bzw. 25 läuft in der Umlaufrichtung 12 geschlossen um den Gehäuseinnenraum 3 um, in dem die Leiterbrücken 5 angeordnet sind.

Bei der in Fig. 15 gezeigten Ausführungsform ist die jeweilige Seitenwand 9 bzw. 10 als ebenes Blech, also als zweidimensionale Struktur ausgestaltet. Erkennbar ist ein in der Umlaufrichtung 12 geschlossen umlaufender Umlauf 26, der ebenfalls den Modulinnenraum 3 einfasst, in dem die Leiterbrücken 5 angeordnet sind. Die Leiterbrücken 5 sind hierbei nicht dargestellt, vielmehr sind die Klebstoffschicht 19 der Figuren 3 und 9, die Metallbeschichtung der Figuren 4 und 10, die Metallbeschichtung 22 der Figuren 6 und 12 sowie die Metallbeschichtung 23 der Figuren 7 und 13 erkennbar. Zweckmäßig besitzt der Umlauf 26 dieselbe Struktur wie die genannten Schichten 19, 20, 22, 23, die bei der jeweiligen Seitenwand 9 oder 10 zur Anwendung kommen, um die Leiterbrücken 5 daran zu fixieren.

Gemäß Fig. 16 können die Kaltseitenwand 9 und die Warmseitenwand 10 entlang der zuvor genannten Stufen 24 und 25 unmittelbar miteinander verlötet sein. Das Modulgehäuse 2 besteht dann im Wesentlichen nur aus der Kaltseitenwand 9 und der Warmseitenwand 10.

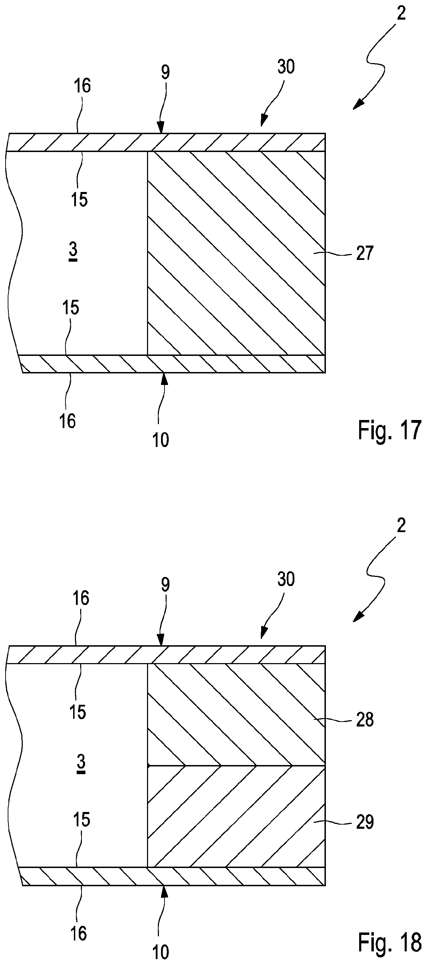

Bei der in Fig. 17 gezeigten Ausführungsform ist zwischen der Kaltseitenwand 9 und der Warmseitenwand 10 im Bereich des in der Umfangsrichtung 12 umlaufenden Randbereichs 30 ein bezüglich der Seitenwände 9, 10 separater Verbindungsrahmen 27 vorgesehen, der einerseits mit der Kaltseitenwand 9 und andererseits mit der Warmseitenwand 10 verlötet ist. Der Verbindungsrahmen 27 ist zweckmäßig in der Umlaufrichtung 12 vollständig geschlossen umlaufend ausgestaltet. Die elektrischen Kontakte 6 sind auf geeignete Weise durch den Verbindungsrahmen 27 hindurchgeführt. In diesem Fall besteht das Modulgehäuse 2 im Wesentlichen aus den beiden Seitenwänden 9, 10 und dem Verbindungsrahmen 27.

Schließlich zeigt Fig. 18 eine Ausführungsform, bei welcher die Kaltseitenwand 9 einen Kaltseitenrahmen 28 aufweist, der im Randbereich entlang der Umlaufrichtung 12 geschlossen umläuft und den Gehäuseinnenraum 3 einfasst. In diesem Fall ist auch die Warmseitenwand 10 mit einem Warmseitenrahmen 29 ausgestattet, der entlang der Umlaufrichtung 12 geschlossen um den Modulinnenraum 3 umläuft. Der Kaltseitenrahmen 28 ist mit dem Warmseitenrahmen 29 zweckmäßig verlötet. Grundsätzlich kann der Kaltseitenrahmen 28 mit der Kaltseitenwand 9 verlötet sein. Ebenso kann der Warmseitenrahmen 29 mit der Warmseitenwand 10 verlötet sein. Bevorzugt ist jedoch die in Fig. 15 angedeutete Ausführungsform, bei welcher der Kaltseitenrahmen 28 wie die kaltseitigen Leiterbrücken 5 an der Kaltseitenwand 9 angebracht ist. Ebenso kann der Warmseitenrahmen 29 wie die warmseitigen Leiterbrücken 5 an der Warmseitenwand 10 angebracht sein. Insbesondere kann somit auch der in Fig. 15 angedeutete Umlauf 26 zur Anwendung kommen, der beispielsweise durch eine Klebstoffschicht 19 oder durch eine Metallschicht 20 oder 22 oder 23 gebildet sein kann, mit deren Hilfe auch die jeweiligen Leiterbrücken 5 an der jeweiligen Seitenwand 9 oder 10 befestigt werden. In diesen Fällen ist die jeweilige Beschichtung 13 oder 14 dann bis zum Rand der jeweiligen Seitenwand 9, 10 realisiert, was die Produktion vereinfacht. Sofern der jeweilige Rahmen 28, 29 ebenso wie der Verbindungsrahmen 27 mit der zugehörigen Seitenwand 9, 10 verlötet ist, erstreckt sich die jeweilige Beschichtung 13, 14 zumindest an der jeweiligen Innenseite 15 zweckmäßig nicht bis zum Rand der jeweiligen Seitenwand 9, 10, insbesondere bleibt der Randbereich 30 frei von der jeweiligen Beschichtung 13, 14.

## Patentansprüche

1. Thermoelektrisches Modul,
- mit einem metallischen Modulgehäuse (2), das einen Modulinnenraum (3) umschließt,
- mit mehreren im Modulinnenraum (3) angeordneten thermoelektrischen Elementen (4),
- mit mehreren im Modulinnenraum (3) angeordneten Leiterbrücken (5) zum elektrischen Verschalten der thermoelektrischen Elemente (4),
- wobei das Modulgehäuse (2) an seiner Kaltseite (7) eine Kaltseitenwand (9) aufweist, die mit mehreren kaltseitigen Leiterbrücken (5) wärmeleitend, elektrisch isoliert und fest verbunden ist,
- wobei das Modulgehäuse (2) an seiner Warmseite (8) eine Warmseitenwand (10) aufweist, die mit mehreren warmseitigen Leiterbrücken (5) wärmeleitend, elektrisch isoliert und fest verbunden ist,
- wobei sich die thermoelektrischen Elemente (4) zwischen den kaltseitigen und warmseitigen Leiterbrücken (5) erstrecken,
- wobei die Kaltseitenwand (9) aus einem ersten Metallwerkstoff gebildet ist, während die Warmseitenwand (10) aus einem zweiten Metallwerkstoff gebildet ist,
- wobei der erste Metallwerkstoff einen ersten Wärmeausdehnungskoeffizienten aufweist und der zweite Metallwerkstoff einen zweiten Wärmeausdehnungskoeffizienten aufweist,
- wobei der zweite Wärmeausdehnungskoeffizient von dem ersten Wärmeausdehnungskoeffizienten verschieden ist,
**dadurch gekennzeichnet,**
- **dass** zumindest einer der Metallwerkstoffe ein Eisenwerkstoff ist, wobei die daraus gebildete Wand (9, 10) eine elektrisch isolierende, glaskeramische Sol-Gel- oder Silizium(di)oxid- oder Polysilazen-Beschichtung (14) aufweist.

2. Modul nach Anspruch 1,
**dadurch gekennzeichnet,**
- **dass** der erste Metallwerkstoff ein Eisenwerkstoff ist, wobei die Kaltseitenwand (9) eine elektrisch isolierende, glaskeramische Sol-Gel- oder Silizium(di)oxid- oder Polysilazen-Beschichtung (14) aufweist, und
- **dass** der zweite Metallwerkstoff ein Eisenwerkstoff ist, wobei die Warmseitenwand (10) eine elektrisch isolierende, glaskeramische Sol-Gel- oder Silizium(di)oxid- oder Polysilazen-Beschichtung (14) aufweist.

3. Modul nach Anspruch 1,
**dadurch gekennzeichnet,**
- **dass** der erste Metallwerkstoff ein Eisenwerkstoff ist, wobei die Kaltseitenwand (9) eine elektrisch isolierende, glaskeramische Sol-Gel- oder Silizium(di)oxid- oder Polysilazen-Beschichtung (14) aufweist, und
- **dass** der zweite Metallwerkstoff ein Titanwerkstoff ist, wobei die Warmseitenwand (10) eine elektrisch isolierende Eloxalschicht (13) aufweist.

4. Modul nach Anspruch 1,
**dadurch gekennzeichnet,**
- **dass** der erste Metallwerkstoff ein Aluminiumwerkstoff ist, wobei die Kaltseitenwand (9) eine elektrisch isolierende Eloxalschicht (13) aufweist, und
- **dass** der zweite Metallwerkstoff ein Eisenwerkstoff ist, wobei die Warmseitenwand (10) eine elektrisch isolierende, glaskeramische Sol-Gel- oder Silizium(di)oxid- oder Polysilazen-Beschichtung (14) aufweist.

5. Modul nach einem der Ansprüche 1 bis 4,
**dadurch gekennzeichnet,**
**dass** der zweite Wärmeausdehnungskoeffizient kleiner ist als der erste Wärmeausdehnungskoeffizient.

6. Modul nach Anspruch 2 oder 5,
**dadurch gekennzeichnet,**
- **dass** der erste Metallwerkstoff ein austenitischer Eisenwerkstoff, vorzugsweise ein austenitischer Stahlwerkstoff, insbesondere ein austenitischer Edelstahlwerkstoff, ist, und
- **dass** der zweite Metallwerkstoff ein ferritischer Eisenwerkstoff oder ein ferritischer Stahlwerkstoff oder ein ferritischer Edelstahlwerkstoff ist.

7. Modul nach einem der Ansprüche 1 bis 6,
**dadurch gekennzeichnet,**
**dass** die Leiterbrücken (5) auf die jeweilige Eloxalschicht (13) oder auf die jeweilige Sol-Gel- oder Silizium(di)oxid- oder Polysilazen-Beschichtung (14) thermisch aufgespritzt sind.

8. Modul nach Anspruch 7,
**dadurch gekennzeichnet,**
**dass** die Leiterbrücken (5) mehrlagig aufgespritzt sind und eine auf die jeweilige Eloxalschicht (13) oder auf die jeweilige Sol-Gel- oder Silizium(di)oxid- oder Polysilazen-Beschichtung (14) aufgespritzte erste Lage (17) aus einem Aluminiumwerkstoff oder aus einem Titanwerkstoff oder aus einem Eisenwerkstoff und eine auf die erste Lage (17) aufgespritzte zweite Lage (18) aus einem Kupferwerkstoff oder aus einem Nickelwerkstoff aufweisen.

9. Modul nach einem der Ansprüche 1 bis 8,
**dadurch gekennzeichnet,**
**dass** die Leiterbrücken (5) als separate Bauteile ausgestaltet sind und auf die jeweilige Eloxalschicht (13) oder auf die jeweilige Sol-Gel- oder Silizium(di)oxid- oder Polysilazen-Beschichtung (14) aufgeklebt sind.

10. Modul nach einem der Ansprüche 1 bis 9,
**dadurch gekennzeichnet,**
- **dass** auf die jeweilige Eloxalschicht (13) oder auf die jeweilige Sol-Gel- oder Silizium(di)oxid- oder Polysilazen-Beschichtung (14) zumindest im Bereich der jeweiligen Leiterbrücken (5) eine Metallschicht (20; 22; 23) aufgebracht ist,
- **dass** die jeweilige Leiterbrücke (5) auf die Metallschicht (20; 22; 23) aufgalvanisiert ist oder als separates Bauteil ausgestaltet und auf die Metallschicht (20; 22; 23) aufgelötet ist.

11. Modul nach einem der Ansprüche 1 bis 10,
**dadurch gekennzeichnet,**
**dass** die Leiterbrücken (5) auf die jeweilige Eloxalschicht (13) oder auf die jeweilige Sol-Gel- oder Silizium(di)oxid- oder Polysilazen-Beschichtung (14) aufgedruckt und eingebrannt sind.

12. Modul nach einem der Ansprüche 1 bis 11,
**dadurch gekennzeichnet,**
**dass** die Kaltseitenwand (9) entlang eines den Gehäuseinnenraum (3) zwischen Kaltseite (7) und Warmseite (8) in einer Umlaufrichtung (12) einfassenden Randbereichs (30) direkt mit der Warmseitenwand (10) verlötet ist.

13. Modul nach einem der Ansprüche 1 bis 12,
**dadurch gekennzeichnet,**
**dass** zwischen der Kaltseitenwand (9) und der Warmseitenwand (10) im Bereich eines den Gehäuseinnenraum (3) zwischen Kaltseite (7) und Warmseite (8) in einer Umlaufrichtung (12) einfassenden Randbereichs (30) ein separater Verbindungsrahmen (27) vorgesehen ist, der mit der Kaltseitenwand (9) und mit der Warmseitenwand (10) verlötet ist.

14. Modul nach einem der Ansprüche 1 bis 12,
**dadurch gekennzeichnet,**
- **dass** die Kaltseitenwand (9) einen Kaltseitenrahmen (28) aufweist, der entlang eines den Gehäuseinnenraum (3) zwischen der Kaltseite (7) und der Warmseite (9) in einer Umlaufrichtung (12) einfassenden Randbereichs (30) des Modulgehäuses (2) geschlossen umläuft und an der Kaltseitenwand (9) angebracht ist,
- **dass** die Warmseitenwand (10) einen Warmseitenrahmen (29) aufweist, der entlang des Randbereichs (30) geschlossen umläuft und an der Warmseitenwand (10) angebracht ist,
- **dass** der Kaltseitenrahmen (28) mit dem Warmseitenrahmen (29) verlötet ist.

15. Modul nach Anspruch 14,
**dadurch gekennzeichnet,**
- **dass** der Kaltseitenrahmen (28) wie die jeweiligen kaltseitigen Leiterbrücken (5) an der Kaltseitenwand (9) angebracht ist, und/oder
- **dass** der Warmseitenrahmen (29) wie die jeweiligen warmseitigen Leiterbrücken (5) an der Warmseitenwand (10) angebracht ist.

## Claims

1. Thermoelectric module,
- comprising a metallic module housing (2) which surrounds a module interior (3),
- comprising a plurality of thermoelectric elements (4) arranged in the module interior (3),
- comprising a plurality of conductor bridges (5) arranged in the module interior (3) for electrically interconnecting the thermoelectric elements (4),
- wherein the module housing (2) has a cold side wall (9) on its cold side (7), the cold side wall being connected to a plurality of cold-side conductor bridges (5) in a thermally conductive, electrically insulating and permanent manner,
- wherein the module housing (2) has a warm side wall (10) on its warm side (8), the warm side wall (10) being connected to a plurality of warm-side conductor bridges (5) in a thermally conductive, electrically insulating and permanent manner,
- wherein the thermoelectric elements (4) extend between the cold-side conductor bridges and the warm-side conductor bridges (5),
- wherein the cold side wall (9) is formed from a first metal material, whereas the warm side wall (10) is formed from a second metal material,
- wherein the first metal material has a first coefficient of thermal expansion and the second metal material has a second coefficient of thermal expansion,
- wherein the second coefficient of thermal expansion is different from the first coefficient of thermal expansion,
**characterised in that**
- at least one of the metal materials is an iron material, the wall (9, 10) formed therefrom having an electrically insulating, glass-ceramic sol-gel or silicon (di)oxide or polysilazane coating (14).

2. Module according to claim 1,
**characterised in that**
- the first metal material is an iron material, the cold side wall (9) having an electrically insulating, glass-ceramic sol-gel or silicon (di)oxide or polysilazane coating (14), and
- the second metal material is an iron material, the warm side wall (10) having an electrically insulating, glass-ceramic sol-gel or silicon (di)oxide or polysilazane coating (14).

3. Module according to claim 1,
**characterised in that**
- the first metal material is an iron material, the cold side wall (9) having an electrically insulating, glass-ceramic sol-gel or silicon (di)oxide or polysilazane coating (14), and
- the second metal material is a titanium material, the warm side wall (10) having an electrically insulating anodized layer (13).

4. Module according to claim 1,
**characterised in that**
- the first metal material is an aluminium material, the cold side wall (9) having an electrically insulating anodised layer (13), and
- the second metal material is an iron material, the warm side wall (10) having an electrically insulating, glass-ceramic sol-gel or silicon (di)oxide or polysilazane coating (14).

5. Module according to any of claims 1 to 4,
**characterised in that**
the second coefficient of thermal expansion is smaller than the first coefficient of thermal expansion.

6. Module according to claim 2 or 5,
**characterised in that**
- the first metal material is an austenitic iron material, preferably an austenitic steel material, in particular an austenitic stainless steel material, and
- the second metal material is a ferritic iron material or a ferritic steel material or a ferritic stainless steel material.

7. Module according to any of claims 1 to 6,
**characterised in that**
the conductor bridges (5) are thermally sprayed onto the respective anodised layer (13) or onto the respective sol-gel or silicon (di)oxide or polysilazane coating (14).

8. Module according to claim 7,
**characterised in that**
the conductor bridges (5) are sprayed on in multiple layers and have a first layer (17) of an aluminium material or of a titanium material or of an iron material sprayed onto the respective anodised layer (13) or onto the respective sol-gel or silicon (di)oxide or polysilazane coating (14), and a second layer (18) of a copper material or of a nickel material sprayed onto the first layer (17).

9. Module according to any of claims 1 to 8,
**characterised in that**
the conductor bridges (5) are configured as separate components and are glued onto the respective anodised layer (13) or onto the respective sol-gel or silicon (di)oxide or polysilazane coating (14).

10. Module according to any of claims 1 to 9,
**characterised in that**
- a metal layer (20; 22; 23) is applied onto the respective anodised layer (13) or onto the respective sol-gel or silicon (di)oxide or polysilazane coating (14) at least in the region of the conductor bridges (5), and
- the conductor bridge (5) is galvanised onto the metal layer (20; 22; 23) or configured as a separate component and soldered onto the metal layer (20; 22; 23).

11. Module according to any of claims 1 to 10,
**characterised in that**
the conductor bridges (5) are printed onto and burnt into the respective anodised layer (13) or the respective sol-gel or silicon (di)oxide or polysilazane coating (14).

12. Module according to any of claims 1 to 11,
**characterised in that**
the cold side wall (9) is soldered directly to the warm side wall (10) along an edge region (30) surrounding the housing interior (3) between the cold side (7) and the warm side (8) in a circumferential direction (12).

13. Module according to any of claims 1 to 12,
**characterised in that**
a separate connecting frame is provided between the cold side wall (9) and the warm side wall (10) in the region of an edge region (30) surrounding the housing interior (3) between the cold side (7) and the warm side (8) in a circumferential direction (12), the separate connecting frame (27) being soldered to the cold side wall (9) and to the warm side wall (10).

14. Module according to any of claims 1 to 12,
**characterised in that**
- the cold side wall (9) has a cold side frame (28) which runs in a closed manner around an edge region (30) of the module housing (2) surrounding the housing interior (3) between the cold side (7) and the warm side (9) in a circumferential direction (12) and which is attached to the cold side wall (9),
- the warm side wall (10) has a warm side frame (29) which runs in a closed manner around the edge region (30) and is attached to the warm side wall (10),
- the cold side frame (28) is soldered to the warm side frame (29).

15. Module according to claim 14,
**characterised in that**
- the cold side frame (28) is attached to the cold side wall (9) like the respective cold-side conductor bridges (5), and/or
- the warm side frame (29) is attached to the warm side wall (10) like the respective warm side conductor bridges (5).

## Revendications

1. Module thermoélectrique,
- avec un boîtier de module (2) métallique, qui entoure un intérieur de module (3),
- avec plusieurs éléments thermoélectriques (4) agencés dans l'intérieur de module (3),
- avec plusieurs ponts conducteurs (5) agencés dans l'intérieur de module (3) et destinés au câblage électrique des éléments thermoélectriques (4),
- dans lequel le boîtier de module (2) comporte au niveau de son côté froid (7) une paroi de côté froid (9) qui est reliée à plusieurs ponts conducteurs (5) côté froid de manière thermoconductrice, électriquement isolée et fixe,
- dans lequel le boîtier de module (2) comporte au niveau de son côté chaud (8) une paroi de côté chaud (10) qui est reliée à plusieurs ponts conducteurs (5) côté chaud de manière thermoconductrice, électriquement isolée et fixe,
- dans lequel les éléments thermoélectriques (4) s'étendent entre les ponts conducteurs (5) côté froid et côté chaud,
- dans lequel la paroi de côté froid (9) est en un premier matériau métallique tandis que la paroi de côté chaud (10) est en un second matériau métallique,
- dans lequel le premier matériau métallique a un premier coefficient de dilatation thermique et le second matériau métallique a un second coefficient de dilatation thermique,
- dans lequel le second coefficient de dilatation thermique est différent du premier coefficient de dilatation thermique,
**caractérisé en ce**
- **qu'**au moins l'un des matériaux métalliques est un alliage ferreux,
dans lequel la paroi (9, 10) formée à partir de ce matériau a un revêtement (14) électriquement isolant, vitrocéramique sol-gel ou de (di)oxyde de silicium ou de polysilazane.

2. Module selon la revendication 1, **caractérisé en ce que**
- le premier matériau métallique est un alliage ferreux,
dans lequel la paroi de côté froid (9) a un revêtement (14) électriquement isolant, vitrocéramique sol-gel ou de (di)oxyde de silicium ou de polysilazane, et
- le second matériau métallique est un alliage ferreux,
dans lequel la paroi de côté chaud (10) a un revêtement (14) électriquement isolant, vitrocéramique sol-gel ou de (di)oxyde de silicium ou de polysilazane.

3. Module selon la revendication 1, **caractérisé en ce que**
- le premier matériau métallique est un alliage ferreux,
dans lequel la paroi de côté froid (9) a un revêtement (14) électriquement isolant, vitrocéramique sol-gel ou de (di)oxyde de silicium ou de polysilazane, et
- le second matériau métallique est un alliage de titane,
dans lequel la paroi de côté chaud (10) a une couche anodique (13) électriquement isolante.

4. Module selon la revendication 1, **caractérisé en ce que**
- le premier matériau métallique est un alliage d'aluminium,
dans lequel la paroi de côté froid (9) a une couche anodique (13) électriquement isolante, et
- le second matériau métallique est un alliage ferreux,
dans lequel la paroi de côté chaud (10) a un revêtement (14) électriquement isolant, vitrocéramique sol-gel ou de (di)oxyde de silicium ou de polysilazane.

5. Module selon l'une quelconque des revendications 1 à 4, **caractérisé en ce que** le second coefficient de dilatation thermique est inférieur au premier coefficient de dilatation thermique.

6. Module selon la revendication 2 ou 5, **caractérisé en ce que**
- le premier matériau métallique est un alliage ferreux austénitique, de préférence un acier austénitique, en particulier un acier spécial austénitique, et
- le second matériau métallique est un alliage ferreux ferritique ou un acier ferritique ou un acier spécial ferritique.

7. Module selon l'une quelconque des revendications 1 à 6, **caractérisé en ce que** les ponts conducteurs (5) sont projetés à chaud sur la couche anodique (13) respective ou sur le revêtement (14) sol-gel ou de (di)oxyde de silicium ou de polysilazane respectif.

8. Module selon la revendication 7, **caractérisé en ce que** les ponts conducteurs (5) sont projetés en plusieurs couches et comportent une première couche (17) en un alliage d'aluminium ou en un alliage de titane ou en un alliage ferreux projetée sur la couche anodique (13) respective ou sur le revêtement (14) sol-gel ou de (di)oxyde de silicium ou de polysilazane respectif et une seconde couche (18) en un alliage de cuivre ou en un alliage de nickel projetée sur la première couche (17).

9. Module selon l'une quelconque des revendications 1 à 8, **caractérisé en ce que** les ponts conducteurs (5) sont réalisés comme des pièces séparées et sont collés sur la couche anodique (13) respective ou sur le revêtement (14) sol-gel ou de (di)oxyde de silicium ou de polysilazane respectif.

10. Module selon l'une quelconque des revendications 1 à 9, **caractérisé en ce que**
- une couche métallique (20 ; 22 ; 23) est appliquée sur la couche anodique (13) respective ou sur le revêtement (14) sol-gel ou de (di)oxyde de silicium ou de polysilazane respectif au moins dans la zone des ponts conducteurs (5) respectifs,
- le pont conducteur (5) respectif est galvanisé sur la couche métallique (20 ; 22 ; 23) ou est réalisé comme une pièce séparée et brasé sur la couche métallique (20 ; 22 ; 23).

11. Module selon l'une quelconque des revendications 1 à 10, **caractérisé en ce que** les ponts conducteurs (5) sont imprimés et gravés sur la couche anodique (13) respective ou sur le revêtement (14) sol-gel ou de (di)oxyde de silicium ou de polysilazane respectif.

12. Module selon l'une quelconque des revendications 1 à 11, **caractérisé en ce que** la paroi de côté froid (9) est brasée directement avec la paroi de côté chaud (10) le long d'une zone marginale (30) englobant l'intérieur de boîtier (3) entre côté froid (7) et côté chaud (8) dans une direction périphérique (12).

13. Module selon l'une quelconque des revendications 1 à 12, **caractérisé en ce qu'**un cadre de liaison séparé (27), qui est brasé avec la paroi de côté froid (9) et avec la paroi de côté chaud (10), est prévu entre la paroi de côté froid (9) et la paroi de côté chaud (10) dans une zone marginale (30) englobant l'intérieur de boîtier (3) entre côté froid (7) et côté chaud (8) dans une direction périphérique (12).

14. Module selon l'une quelconque des revendications 1 à 12, **caractérisé en ce que**
- la paroi de côté froid (9) comporte un cadre de côté froid (28) qui fait tout le tour de manière fermée le long d'une zone marginale (30), englobant l'intérieur de boîtier (3) entre côté froid (7) et côté chaud (9) dans une direction périphérique (12), du boîtier de module (2) et qui est monté sur la paroi de côté froid (9),
- la paroi de côté chaud (10) comporte un cadre de côté chaud (29) qui fait tout le tour de manière fermée le long de la zone marginale (30) et qui est monté sur la paroi de côté chaud (10),
- le cadre de côté froid (28) est brasé avec le cadre de côté chaud (29).

15. Module selon la revendication 14, **caractérisé en ce que**
- le cadre de côté froid (28) est monté sur la paroi de côté froid (9) comme les ponts conducteurs (5) côté froid respectifs, et/ou
- le cadre de côté chaud (29) est monté sur la paroi de côté chaud (10) comme les ponts conducteurs (5) côté chaud respectifs.
